## Europäisches Patentamt
## European Patent Office
## Office européen des brevets

(19)

(11) Publication number: **0 070 667**
**A1**

(12) **EUROPEAN PATENT APPLICATION**

(21) Application number: **82303649.6**

(22) Date of filing: **12.07.82**

(51) Int. Cl.³: **G 05 F 3/20, H 03 K 3/354**

(30) Priority: **13.07.81 US 282506**

(43) Date of publication of application: **26.01.83 Bulletin 83/4**

(84) Designated Contracting States: **DE FR GB NL**

(71) Applicant: **INMOS CORPORATION, P.O. Box 16000, Colorado Springs Colorado 80935 (US)**

(72) Inventor: **Heightley, John Donald, PO Box 490, Monument Colorado 80132 (US)**
Inventor: **Sud, Rahul, 3375 Clubheights Drive, Colorado Springs Colorado 80906 (US)**
Inventor: **Hardee, Kim Carver, 680 Becket Place, Colorado Springs, Colorado 80906 (US)**

(74) Representative: **Palmer, Roger et al, Page, White and Farrer 27 Chancery Lane, London WC2A 1NT (GB)**

(54) **Improved oscillator for a substrate bias generator.**

(57) An oscillator for generating a pair of signals for use in conjunction with clock drivers and a charge pump for driving the voltage on the substrate of a metaloxide-semiconductor (MOS) to a negative potential includes a Schmitt trigger stage (50a), an RC delay path (38a, 40a) coupled to the output of the Schmitt trigger stage, and a pair of inverters (54a, 56a) from which a feedback signal is applied to the Schmitt trigger stage. Another RC delay path (34a, 36a) is provided between the feedback signal and a first node at the Schmitt trigger stage. The gate and one source/drain terminal of a first depletion mode MOS device (34a) are tied together at the first node (35b). The other source/drain terminal of this transistor is coupled to a second node (35a) which is connected to both the Schmitt trigger stage and to a second depletion mode MOS device (36a). This second MOS device capactively couples the second node to ground. The first MOS device provides a low impedance path for charging a signal on the second node and a high impedance path for discharging the signal on the second node. As a result, the duty cycle of the signal generated on the second node is increased, thereby improving the pumping efficiency of the substrate bias generator.

Improved Oscillator for a Substrate Bias Generator

The invention relates to the field of metal-oxide-semiconductor memory devices and, more particularly, to an improved oscillator to be used in conjunction with timing circuitry and a charge pump for random access memories.

A negative bias voltage is typically applied by a back bias generator to the substrate of a metal-oxide-semiconductor (MOS) random access memory (RAM) in order to improve the performance of the MOS circuit. The applied negative voltage, generally about minus 3.5 volts with respect to ground, lowers the junction capacitance between N+ doped silicon layers and the P- doped silicon substrate and improves the threshold stability, and punch through characteristics of the transistors. As a result, the MOS circuit operates at a faster speed and more reliably.

In previous generations of memory devices, the back bias voltage was developed externally to the memory chip. Lately, back bias voltages have been generated on the chips themselves by using a charge pump driven by a self starting oscillator to develop a negative back bias voltage. The most recent substrate bias generator is capable of developing a substrate potential below the minus 3.5 volt level by eliminating a threshold voltage drop associated with the generator. However, the pumping efficiency and the reliability, with respect to process parameter variations of the substrate bias generator has been limited by the duty cycle of the signals generated from the oscillator circuitry.

A general object of the invention is to provide an improved, on-chip, oscillator to be used in conjunction with a back bias generator.

A more specific object of the invention is to provide an improved oscillator to be used in an on-chip back bias generator for developing a well controlled, more negative voltage than previously obtainable so as to attain faster circuit speed and further minimise threshold voltage variations in the memory chip due to variations in the potential between the source of an MOS transistor and the substrate, as well as reduce the possibility of charge injection in case of substrate bounce.

Another object of the invention is to provide an improved oscillator which enables a substrate bias generator to attain a faster pump down for a given frequency by achieving greater charge transfer per cycle.

A further object of the invention is to provide an improved oscillator which will generate signals for application to a charge pump that have a better duty cycle than previous obtainable for developing a more controlled, negative voltage.

Other objects will become apparent in the detailed description of the invention.

FIG. 1 illustrates a block drawing of an oscillator shown in combination with clock drivers and a charge pump for developing a substantially constant negative bias voltage.

FIG. 2 illustrates the circuit details of a prior art oscillator.

FIG. 3 illustrates a preferred embodiment of the improved oscillator which is shown in combination with a pair of clock drivers and a charge pump.

The present invention provides an improved oscillator for use with drivers and a charge pump in a substrate bias generator. The improved oscillator enables the signals generated from the clock drivers to have a higher duty cycle as they are applied to the charge pump. Accordingly, the efficiency and reliability of the substrate bias generator is increased.

In a preferred embodiment, the oscillator is a self-starting oscillator which includes a first RC delay path coupled to the input of a Schmitt trigger stage. The output of the Schmitt trigger stage is coupled via a second RC delay path to a pair of inverters which send a feedback signal back to the first RC delay path.

According to the invention, an improvement is disclosed in the RC delay path associated with the feedback signal. This RC delay circuit includes two MOS depletion mode MOS devices, one functioning as a resistor and the other functioning as a capacitor. The resistor-type functioning MOS device is a bi-directional device in that the source terminal and drain terminal are interchangeable depending upon the potential present at each terminal. The source is determined by whichever terminal has the lower potential applied thereon. Therefore, each terminal hereinafter shall be called a source/drain terminal to reflect this interchangeable character. The two devices are arranged such that the gate of the resistor-type functioning MOS device is coupled to one of its source/drain terminals at a node which also receives the feedback signal from one of the inverters. As a result of this connection, the frequency of the oscillator is decreased. In order to reach the previously desired frequency, the width/length sizing of the resistor-type MOS device is increased. The other source/drain terminal of the resistor-type device is coupled via a second node to the gate of the capacitor-type functioning MOS device. The drain and source of this device are tied together and coupled to ground. By coupling the gate and one source/drain terminal of the resistor-type MOS device to the feedback signal, the capacitor-type MOS device is provided with a low impedance charge path and a high impedance discharge path. The aforementioned circuit enables the oscillator to increase the duty cycle of the signal on the second node which is then applied to the Schmitt trigger stage. As a result, the signals generated by the oscillator for input to the clock drivers have increased duty cycles. Ultimately, the signals generated by the clock drivers for driving the charge pump have longer duty cycles which have been increased from approximately 34% to 70%. The charge pump drives the potential on the substrate negative during the duty cycle of the signals generated by the clock drivers. Accordingly, the potential on the substrate is driven further negative during each pumping cycle of the charge pump to reach a preferred negative potential more rapidly.

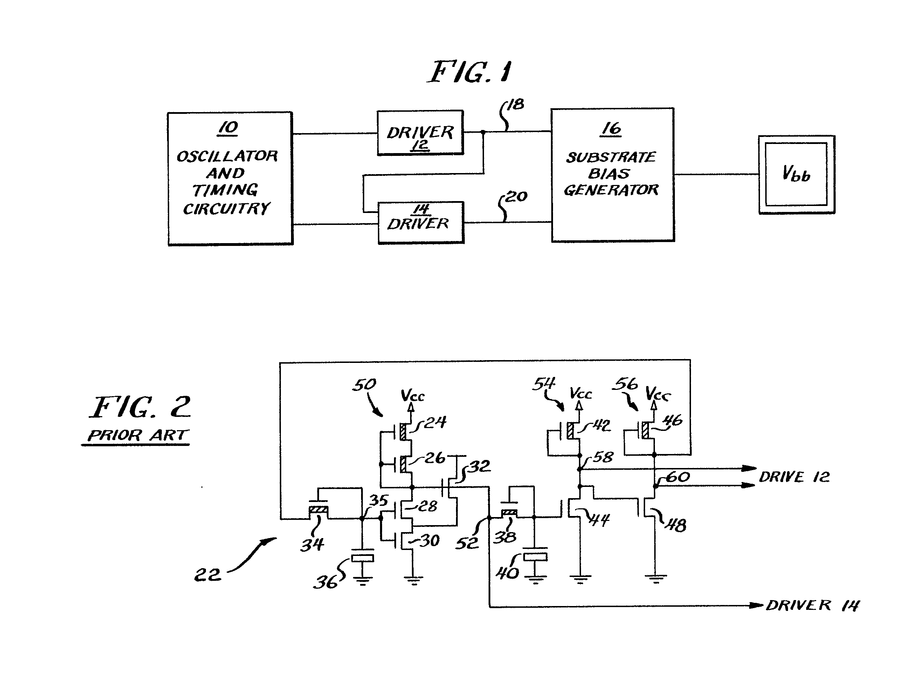

In co-pending European Patent Application No 81302872.7 the disclosure of which is incorporated herein, a substrate bias generator is illustrated which applies a negative voltage to the substrate of MOS integrated circuits. Referring to Fig. 1, a block diagram of a substrate bias generator shows an oscillator 10 in combination with a pair of clock drivers 12 and 14 and a charge pump 16 for applying a back bias negative voltage ($V_{bb}$) to the substrate of an MOS circuit (not shown). This general arrangement is shown in said co-pending application.

The oscillator 10 is connected to drivers 12 and 14 for producing a first train of periodic pulses at an input terminal 18 and a second train of periodic pulses at an input terminal 20. The waveforms generated at input terminals 18 and 20 have the same frequency, approximately five megahertz in the preferred embodiment, are phase synchronized, and have amplitudes of about 5 volts. However, the waveform produced at input terminal 18 by the first train of periodic pulses has a greater duty cycle than the waveform produced at input terminal 20 by the second train of periodic pulses. A duty cycle is defined as the high time of a signal during one cycle of the signal divided by the total time of one cycle of the signal. The waveforms overlap in such a manner that the waveform at input terminal 20 is enclosed within the waveform at input terminal 18. This overlapping effect is generated by the clock drivers 12 and 14. The overlap between waveforms assures that there is a sufficient time period, ten nanoseconds, for example, between the rise in voltage potential at the input terminal 18 and the rise in voltage potential at the input terminal 20, as well as a sufficient time period between the fall in voltage potential at input terminal 20 and the fall in voltage potential at input terminal 18. These voltage transitions are applied to the charge pump 16 and enable the substrate bias generator to pump the potential on the substrate to a preferred negative level.

Referring to Fig. 2, a prior art oscillator 22 is shown which has been previously used as the oscillator 10 in conjunction with the pair of drivers 12 and 14 and the charge pump 16 of Fig. 1 for applying a negative voltage to the substrate of an MOS circuit. Oscillator 22 is a self-starting, three-stage oscillator which includes MOS devices 24-28. A Schmitt-type trigger stage 50, formed by depletion mode transistors 24 and 26 and enhancement mode transistors 28, 30 and 32, functions as an inverter in response to the voltage at the node reaching a threshold value. The Schmitt trigger stage 50 is used because it requires less stages and, therefore, less power for a given frequency than a conventional ring oscillator. As a result, signals with cleaner waveforms are applied to the drivers 12 and 14 in Fig. 1. The output of the Schmitt trigger stage 50 at node 52 is delivered to the remaining oscillator stages and to driver 14.

An RC delay path is formed by depletion mode MOS devices 34 and 36 at the input to the Schmitt trigger stage 50. The MOS device 34 functions as a resistor while the MOS device 36 operates as a capacitor. The gate and one source/drain terminal of the MOS device 34 are tied together at node 35 and coupled to the MOS device 36. The other source/drain terminal of the MOS device 34 received a feedback signal. A similar RC delay path is formed by depletion mode MOS devices 38 and 40 to receive the signal on node 52 from the Schmitt stage 50 and to apply a delayed signal to a pair of inverters 54 and 56. These delay paths set the pulse width of the oscillator 22 which, in turn, determines its frequency. Inverter 54, formed by depletion mode transistor 42 and enhancement mode transistor 44, drives inverter 56 which is defined by depletion mode transistor 46 and enhancement mode transistor 48. Inverter 54 also provides a first input to driver 12 at node 58. Inverter 56 provides a feedback loop to the transistor 34 and a second input to driver 12 at node 60.

One problem with the oscillator illustrated in Fig. 2 is that the MOS device 34 provides a high impedance charge path and a low impedance discharge path for the capacitor-acting MOS device 36. Accordingly, the capacitor 36 charges slowly and discharges quickly. As a result, the signal generated on node 35 has a shorter than desired duty cycle. This shorter than desired duty cycle causes the signals generated by the oscillator 22 and applied to the drivers 12 and 14 to have correspondingly short duty cycles. Consequently, the drivers 12 and 14 also generate signals having shorter than desired duty cycles. The short duty cycle signals from the drivers 12 and 14 are subsequently applied to the input terminals 18 and 20 for driving the charge pump 16. However, these short duty cycle signals prevent the charge pump from quickly driving the potential on the substrate to a preferred negative value.

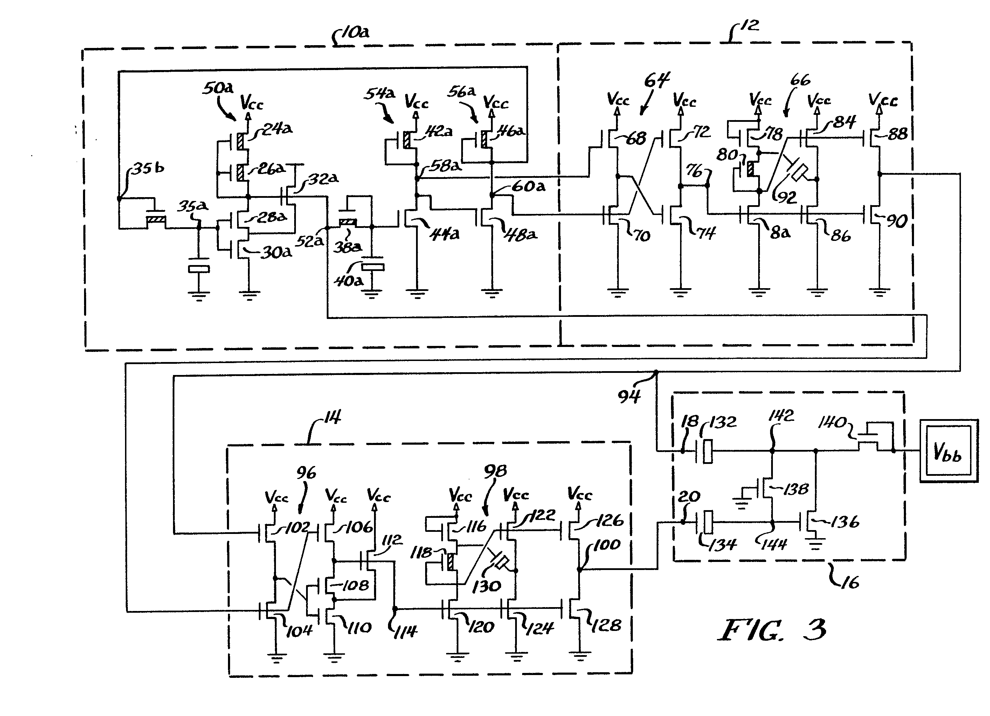

In contrast to the circuit of Fig. 2, the preferred embodiment of the invention employs an improved oscillator 10a, as shown in Fig.3, which ultimately enables the signals on the input terminals 18 and 20 to have larger duty cycles. Oscillator 10a is a self-starting oscillator which is very similar to the prior art oscillator 22 except for one important connection and the sizing of a related MOS device. These distinctions are disclosed in detail below.

Oscillator 10a includes a Schmitt-type trigger stage 50a formed by depletion mode transistors 24a and 26a and enhancement mode transistors 28a, 30a, and 32a. The Schmitt trigger stage 50a takes an input signal from node 35a and generates an inverted output signal at node 52a when a predetermined voltage level is reached at node 35a. The output signal of the Schmitt trigger stage 50a at node 52a is subsequently applied to the remaining stages of the oscillator 10a and to the clock driver 14.

Two RC delay paths are coupled to the Schmitt stage 50a. The first RC delay path formed by depletion mode MOS devices 34a and 36a is connected to the other node 35a as the input to the Schmitt trigger stage 50a. The other RC delay path formed by depletion mode MOS devices 38a and 40a is connected to the output of the Schmitt stage 50a at the node 52a. The latter RC delay path is identical to that utilized in the prior art. The two RC delay paths set the frequency and duty cycle of the oscillator 10a which, in turn, determines the frequency and duty cycle of the signals applied to the charge pump.

The MOS devices 38a and 40a are coupled to a pair of inverters 54a and 56a. These inverters are also identical to that used in the prior art. Inverter 54a, formed by depletion mode transistor 42a and enhancement mode transistor 44a, drives inverter 56a which is arranged from depletion mode transistor 46a and enhancement mode transistor 48. Inverter 54a also applies a first input signal at node 58a to the driver 12. Inverter 56a applies a second input signal at node 60a to the driver 12. Also, inverter 56a applies a second input signal at node 60a to the driver 12. Also, inverter 56a applies a feedback signal from node 62a to the MOS device 34a of the first RC delay path at node 35b.

Referring specifically to the first RC delay path, the depletion mode MOS device 34a functions as a resistor and the depletion mode MOS device 36a operates as a capacitor. The gate of the MOS device 34a is tied at node 35b to one source/drain terminal of the MOS device 34a. This source/drain terminal functions as a drain during the charging of the RC delay path and as a source during the discharging of the RC delay path. The other source/drain terminal of the MOS device 34a is coupled at node 35a to the gate of capacitor-functioning MOS device 36a. This terminal functions as a source during charging of the RC delay path and as a drain during discharging of the RC delay path. The MOS device 36a has its two source/drain terminals tied together and coupled to ground.

The above mentioned RC delay path receives a feedback signal from inverter 56a at the node 35b and generates a signal on node 35a. The charge built up on node 35a by the RC delay path is applied as the input to the Schmitt trigger 50a. By connecting the gate of the MOS device 34a to the node 35b, a very significant improvement is achieved. The duty cycle of the signal on node 35a is increased. As a result, the signals generated by the oscillator 10a have longer duty cycles. However, this connection also decreases the frequency of the signals generated by the oscillator 10a. In order to operate the oscillator at the preferred faster frequency, the width/length ratio of the MOS device 34a is substantially increased to a ratio of 6/30. The prior art size of the resistor-type MOS device in this RC delay path was 6/70.

The signals with longer duty cycles from the oscillator 10a are applied to the drivers 12 and 14 to generate signals with correspondingly longer duty cycles than that previously attained. In the fact, the duty cycles of each signal are improved from approximately 34% to 70% of the total cycle. These longer duty cycle signals from the clock drivers 12 and 14 are subsequently applied to the input terminals 18 and 20 to drive the charge pump 16. As a result, pumping by the charge pump 16 is performed more efficiently as the potential of the substrate is driven further negative during each pump cycle of the substrate bias generator.

The remainder of Fig. 3 discloses detailed circuitry for the clock drivers 12 and 14 and the charge pump 16 which are to be used with the preferred embodiment. Driver 12 receives signals from the nodes 58a and 60a in the oscillator 10a and produces a first train of periodic pulses which is delivered to input terminal 18 for creating potential transitions in the charge pump 16. The same train of periodic pulses is also applied as input to the driver 14.

Clock driver 12 includes timing circuitry 64 and bootstrap clock driver circuitry 66. Timing circuitry 64, defined by enhancement mode transistors 68-74, is arranged as a pair of push-pull enhancement drivers for producing alternating high and low input signals at node 76 for introduction into bootstrap clock driver circuitry 66. Bootstrap driver 66, defined by transistors 78-90 and capacitor 92, is discussed in detail in a related European Patent Application No 81302873.5.

Bootstrap driver 66 basically inverts its input signal at node 76 from high to low and vice versa to provide a first train of periodic pulses at node 94 for delivery to input terminal 18 and driver 14.

Clock driver 14 includes timing circuitry 96 and bootstrap clock driver circuitry 98 and produces a second train of periodic pulses at node 100 for delivery to input terminal 20. Timing circuitry 96, defined by enhancement mode transistors 102-112, produces alternating high and low input signals at node 114 for delivery to bootstrap driver 98. Timing circuitry 96 has a slow pull down delay due to the Schmitt action created by in series transistors 108 and 110. Bootstrap driver 98, which is formed by associated transistors 116-128 and capacitor 130, performs similarly to bootstrap driver 66 to generate a second train of periodic pulses at node 100. The pulses at node 94 have longer duty cycles than the pulses at node 100 due to the differences created by timing circuitries 64 and 96.

The charge pump 16, formed by capacitors 132 and 134 and transistors 136-140, receives the pulses from clock drivers 12 and 14 at input terminals 18 and 20 and biases the substrate to an increasingly lower negative potential during each pump cycle until a certain level is reached. Thereafter, the negative potential on the substrate is substantially maintained. A node 142 is coupled via capacitor 132 to input terminal 18 so as to receive positive and negative voltage transitions derived from positive and negative amplitude transitions in the first train of periodic pulses at input terminal 18. Similarly, node 144 is coupled via capacitor 134 to input terminal 20 so as to receive positive and negative voltage transitions derived from positive and negative amplitude transitions in the second train of periodic pulses at input terminal 20. The amplitude transitions of the periodic pulses at input terminals 18 and 20 drive the potentials at nodes 142 and 144 positive and negative. The potentials at nodes 142 and 144 are employed to develop a negative bias voltage on the substrate.

Transistor 136 is connected between node or junction 142 and ground. Node 144 is coupled to the gate of transistor 135 for clamping node 142 to ground during the on time of each pulse in the second train of periodic pulses at input terminal 20. Transistor 138 is connected between nodes 142 and 144 with its gate biased to ground for coupling the potential of node 144 toward the potential of node 142. Transistor 140 is connected between node or junction 142 and the substrate for activation whenever the potential of node 142 is more than the threshold voltage of transistor 140 below the potential of the substrate.

When transistor 140 is turned on, current flows between the substrate and node 142 so that the potential on substrate 16a is pumped within one threshold voltage of the negative potential on node 142. During each pumping cycle, the potential on node 142 is driven negatively an incremental amount until a maximum negative voltage level is reached. The degree of each increment is, up to a certain point, directly proportional to the length of the duty cycles of the signals at the input terminals 18 and 20. As mentioned previously, the improved oscillator 10a ultimately increases the duty cycles of the pulses on input terminals 18 and 20. This is due to the gate of the MOS device 34a being connected to node 35b in the oscillator 10a. This connection provides a low impedance charge path which enables the signal on node 35a to charge up more quickly. The connection also provides a high impedance discharge path which enables the signal on node 35a to discharge more slowly. The combination of quicker charging and slower discharging generates a signal at node 35a which has a higher duty cycle. This increased duty cycle is correspondingly transferred throughout the substrate bias generator system to the signals at input terminals 18 and 20. Accordingly, the potentials at nodes 142 and 144 are driven further negative during the longer duty cycles of the signals at input terminals 18 and 20, thereby driving the potential on the substrate further negative too. Thus, the substrate bias generator operates more efficiently as the potential on the substrate is driven further negative during each pumping cycle to reach a preferred negative potential more rapidly.

In the above description, specific details of an embodiment of the invention have been provided for a thorough understanding of the inventive concepts. It will be understood by those skilled in the art that many of these details may be varied without departing from the spirit and scope of the invention.

0070667

-13-

Claims:

1. In a substrate bias generator an oscillator which develops output signals for use in driving a charge pump and which includes a Schmitt trigger stage followed by an RC delay path and circuitry for feeding back one of the output signals to the Schmitt trigger stage via an input RC delay path, an improved input RC delay path, characterised by a first node for receiving the feedback signal, a first depletion mode MOS device operating as a resistor and having its gate and one of its source/drain terminals together at said first node, a second node coupled between the other source/drain terminal of said first depletion mode transistor and the Schmitt trigger stage, a second depletion mode MOS device operating as a capacitor and coupled between said second node and ground, whereby said first depletion mode MOS device provides a low impedance for the charge path of said input RC delay path and provides a high impedance for the discharge path of said input RC delay path so as to increase the pumping efficiency of the substrate bias generator.

2. The improved input RC delay path of claim 1 wherein said first depletion mode transistor is sized to have a width/length ratio which ensures that the oscillator will operate at a preferred frequency.

3. The improved input RC delay path of claim 2 wherein said first depletion mode MOS device has a width/length ratio of 6/30.

FIG. 1

10
OSCILLATOR
AND
TIMING
CIRCUITRY

DRIVER
12

18

16
SUBSTRATE
BIAS
GENERATOR

Vbb

14
DRIVER

20

FIG. 2

PRIOR ART

Vcc

50

24

26

32

54 Vcc

42

56 Vcc

46

58

DRIVE 12

60

34

35

28

52

38

44

48

22

30

36

40

DRIVER 14

1/2

0070667

FIG. 3

## DOCUMENTS CONSIDERED TO BE RELEVANT

| Category | Citation of document with indication. where appropriate, of relevant passages | Relevant to claim | CLASSIFICATION OF THE APPLICATION (Int. Cl. ³) |
|---|---|---|---|
| X | EP-A-0 030 130 (FUJITSU) *Page 6, line 25 - page 9, line 1; figures 3,4* | 1 | G 05 F 3/20 H 03 K 3/354 |
| A | IBM TECHNICAL DISCLOSURE BULLETIN, vol. 16, no. 1, June 1973, page 317, New York (USA); H.C.CHANG et al.: "Integrated delay circuit/noise rejection circuit". *The whole document* | 1,2 | |
| A | US-A-4 115 710 (TEXAS INSTRUMENTS) *Column 2, line 21 - column 6, line 6; figures 1-4* | 1 | |
| A | US-A-4 122 361 (IBM) *Column 7, lines 31-41; figure 5c* | 1 | **TECHNICAL FIELDS SEARCHED (Int. Cl. ³)** |
| D,E | EP-A-0 043 246 (INMOS) *Abstract; figure 3* | 1 | G 05 F 3/00 H 03 K 3/00 |

The present search report has been drawn up for all claims

| Place of search | Date of completion of the search | Examiner |
|---|---|---|
| THE HAGUE | 13-10-1982 | ZAEGEL B.C. |